# EUROPEAN PATENT APPLICATION

(11) **EP 4 753 397 A1**
(43) Date of publication of application: **03.06.2026**
(21) Application number: 24306998.6
(22) Date of filing: 28.11.2024
(51) Int. Cl.: H10D 1/00, H10D 1/68, H10D 1/66

(54) **ELECTRICAL DEVICE COMPRISING A CAPACITOR WITH A DIELECTRIC STACK AVOIDING WARPAGE**

(71) Applicant: MURATA MANUFACTURING CO., LTD., Nagaokakyo-shi, Kyoto 617-8555 (JP)
(72) Inventor: GABORIEAU, Sophie, 14000 CAEN (FR); TRAVERS, Hervé, 14000 CAEN (FR); BOUVIER, Stéphane, 14000 CAEN (FR)
(74) Representative: Cabinet Beau de Loménie

(57) **Abstract**

The present invention relates to an electrical device comprising a capacitor including:
a bottom electrode structure (110) comprising a silicon substrate (112),
a dielectric stack (120) extending on the bottom electrode structure (110), the dielectric stack (120) comprising at least:
a thermal silicon dioxide layer (121) on the silicon substrate having a thickness comprised between 10% and 20% of the thickness of the dielectric stack,
a SixNy layer (122) on the thermal silicon dioxide layer having a thickness comprised between 45% and 55% of the thickness of the dielectric stack, and
a deposited silicon dioxide layer (123)) on the SixNy layer having a thickness comprised between 35% and 45% of the thickness of the dielectric stack,
a top electrode structure (130) extending on the dielectric stack (120).

## Description

### Field of the invention

The present invention relates to the field of electrical devices. More particularly, it relates to an electrical device comprising a capacitor and a method for manufacturing thereof.

### Description of Related Art

The present invention lies within the context of electrical devices comprising capacitors formed using a semiconductor substrate on which extends a dielectric structure. For instance, the present invention applies to vertical capacitors, wherein the bottom electrode is formed by a highly doped silicon substrate and a backside metallization (i.e., a conductive layer formed on the bottom surface of the substrate)

The invention also lies within the context of high voltage capacitors, for example designed to withstand voltages above 600V or even above 900V. To achieve this, capacitors formed above semiconductor substrates use thick dielectric layers (2 to 2,5µm of ONO (Oxyde-Nitride-Oxyde), for voltages above 900V).

It has been observed that such thick dielectric layers are affected by stress, which can lead to a warpage of the structure (more precisely a warpage of the wafer on which capacitors are formed prior to a dicing step).

Increasing the capacitance of capacitors formed on semiconductor substrate has been implemented by means of 3D structures over which the capacitor electrode face each other following the contours of the 3D structures. This has a negative impact on wafer warpage and deformation.

In devices according to the prior art, top capacitor electrodes comprise phosphorous doped polysilicon deposited by LPCVD which can be deposited within 3D structures. Activating dopants to reduce the resistivity is usually performed through a high temperature annealing (for example from 900°C to 1000°C). The inventors of the present invention have observed that this annealing also has a negative impact on wafer warpage and deformation.

Therefore, there is a need for a solution that allows forming capacitors, for example having thick dielectric layers, on semiconductor substrate while avoiding warpage and deformation.

### Summary of the invention

The present invention has been made in light of the above problems.

The invention proposes an electrical device comprising a capacitor including:
- a bottom electrode structure comprising a silicon substrate,
- a dielectric stack extending on the bottom electrode structure, the dielectric stack comprising at least:
   a thermal silicon dioxide layer (i.e. a silicon dioxide layer obtained by thermal oxidation) on the silicon substrate having a thickness comprised between 10% and 20% of the thickness of the dielectric stack,
   a SiₓN_{y} (silicon nitride, for example silicon rich silicon nitride) layer on the thermal silicon dioxide layer having a thickness comprised between 45% and 55% of the thickness of the dielectric stack, and
   a deposited silicon dioxide layer on the SiₓN_{y} layer having a thickness comprised between 35% and 45% of the thickness of the dielectric stack (in other words, an ONO stack is formed),
- a top electrode structure extending on the dielectric stack.

The inventors of the present invention have observed that the thickness ratios of the layers forming the ONO stack in the above capacitors have an impact on warpage. The inventors have observed that the values 10%, 20%, 45%, 55%, 35%, and 45% listed above are appropriate for limiting the warpage.

This results from the fact that thermal silicon dioxide presents a compressive stress (typically of the order of -330MPa), silicon nitride (for example deposited by LPCVD) presents a tensile stress (typically from 0 to 1200MPa depending on the silicon content, for example stoichiometric silicon nitride (Si3N4) presents a stress of about 1200MP, and increasing the silicon ratio in the layer (i.e. increasing x in SiₓN_{y}) leads to reducing the stress. By way of example, Si_{3.4}N_{3.7} presents a typical internal stress of about 400MPa), and deposited silicon dioxide (for example TEOS) presents a compressive stress (for example of the order of -100MPa). From these values (and from the stress of the other layers forming the device, the thickness values have been determined.

By way of example, a dielectric stack suitable to withstand voltages above 900V can comprise 300nm of thermal silicon dioxide, 1000nm of SixNy, and 800nm of TEOS.

According to a particular embodiment, the top electrode structure comprises doped polysilicon.

For example, the polysilicon is doped with phosphorous. Such polysilicon has been observed to present a tensile stress of the order of 500MPa.

According to a particular embodiment, the doped polysilicon has a sheet resistance of more than 100 Ohm/sq.

This resistance value corresponds to unannealed polysilicon, for example for a thickness of about 800nm.

In order to further limit the stress within the device, the inventors have observed that it is possible not to anneal the polysilicon layer. This results in an increased resistivity for the polysilicon layer, which cannot be achieved when an annealing is performed (typically 10 times smaller resistivity, for example 9,5 Ohm/sq).

Resistivity and sheet resistance of the polysilicon layer can be measured. Also, the doping, for example phosphorous doping, can be measured by Energy Dispersive X Ray Analysis.

This particular embodiment is advantageous for forming RC devices such as RC snubbers, often used for high voltage applications. Also, as the entire polysilicon layer is resistive, it provides a large resistive surface which allows high currents passing through the device.

According to a particular embodiment, the device further comprises a migration barrier layer arranged on the top electrode structure, for example comprising TiW.

For example, the migration barrier layer is continuous and prevents the conductive species deposited above the top electrode structure (typically metallization layers comprising AlSiCu) from migrating within the polysilicon. This is particularly advantageous for non-annealed polysilicon as the polysilicon interfaces between the grains of the polycrystalline structure are not stabilized.

According to a particular embodiment, the method comprises a conductive region arranged on migration barrier layer.

For example, the conductive region comprises AlSiCu.

According to a particular embodiment, the migration barrier layer has a thickness of less than 0.1µm.

According to a particular embodiment, the silicon substrate of the bottom electrode structure comprises a region having at least a concentration of oxygen of at least 1 × 10¹⁷*at*/*cm³.*

Impurities in silicon, especially boron and interstitial oxygen can influence the generation and motion of dislocations in silicon (the mechanism can be referred to as dislocation locking). This has a strong influence on wafer mechanical strength. Also, an additional effect occurs when oxygen precipitates nucleate and grow thanks to high temperature thermal treatment (>1100°C). The substrate is preferably selected to be a highly doped boron substrate (B> 1 × 10¹⁸at/cm³) with O content above 1 × 10¹⁷at/cm³.

The inventors of the present invention have observed that selecting an appropriate substrate also participates to avoiding warpage. In fact, the oxygen content of the substrate has been observed to have an impact on the wafer strength, in particular when the oxygen content is high.

According to a particular embodiment, the dielectric stack has a thickness comprised between 2000 and 2500 nm.

According to a particular embodiment, the bottom electrode structure comprises a surface presenting a relief (e.g., trenches, columns, holes, or pillars), wherein the dielectric stack is arranged at least on the relief in a conformal manner.

This embodiment proposes using a three-dimensional (3D) capacitor using a substrate with reliefs such as trenches, holes, columns, or pillars. This allows increasing the specific area of the capacitor for a given component size. This embodiment thereby provides an electrical device with a high capacitance density.

The invention also proposes a method for manufacturing an electrical device comprising a capacitor, said method comprising:
- providing a bottom electrode structure comprising a silicon substrate;
- forming a dielectric stack extending on the bottom electrode structure, comprising at least:
   forming a thermal silicon dioxide layer on the silicon substrate having a thickness comprised between 10% and 20% of the thickness of the dielectric stack, by thermal oxidation of the silicon substrate,
   depositing a SiₓN_{y} layer on the thermal silicon dioxide layer having a thickness comprised between 45% and 55% of the thickness of the dielectric stack, and depositing silicon dioxide layer on the SiₓN_{y} layer having a thickness comprised between 35% and 45% of the thickness of the dielectric stack,
- forming a top electrode structure extending on the dielectric stack.

This method can be used to obtain any embodiment of the above defined electrical device.

According to a particular embodiment, the top electrode structure comprises doped polysilicon, the method further comprising forming a conductive region above the doped polysilicon, and the polysilicon remains unannealed during at least a continuous period including forming the top electrode structure and the beginning of forming a conductive region, for example by maintaining a temperature of the top electrode structure below 700°Cat least during a continuous period including forming the top electrode and the beginning of forming a conductive region, or at least during a continuous period including forming the top electrode and forming a conductive region..

According to a particular embodiment, the method comprises annealing the silicon substrate of the bottom electrode structure including:
a first annealing phase at a temperature 1050°C -1150°C (for example, this will allow diffusing oxygen present in the substrate);
following the first annealing phase, a second annealing phase at a temperature comprised between 700 and 800°C (for example, this will allow SiOx clusters to nucleate);
following the second annealing phase, a third annealing phase at a temperature of comprised between 1050°C and 1150°C (for example, this will allow SiOx precipitates to grow).

### Brief Description of the Drawings

Further features and advantages of the present invention will become apparent from the following description of certain embodiments thereof, given by way of illustration only, not limitation, with reference to the accompanying drawings in which:
FIG. 1 illustrates a cross-section view of a structure with a dielectric stack according to an example,
FIG. 2 shows the structure of figure 1 with a top electrode structure;
FIG. 3 shows the structure of figure 2 with a migration barrier layer; and
FIG. 4 shows the structure of figure 3 with a conductive region.

### Detailed Description of Example Embodiments

The present invention provides an electrical device comprising a capacitor with a dielectric structure preventing warpage, while allowing having thick dielectric suitable for withstanding high voltages.

The present invention lies, in particular, within the context of 3D capacitors formed using semiconductor substrates. The following description of the invention will refer to this particular context, which is only given as an illustrative example and should not limit the invention. The invention can also be used for planar capacitors.

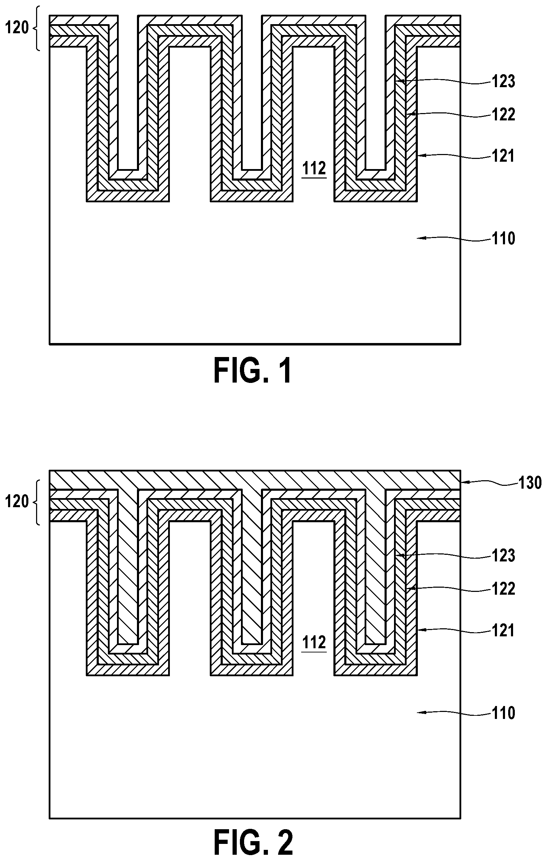

FIG. 1 illustrates a cross-section view of a structure according to an example.

The structure of this figure is formed above a substrate 112 that has been doped and patterned in a photolithography step to obtain a 3D surface forming a bottom electrode structure.

According to an aspect, it is possible to limit warpage by having a substrate 112 having a high content of oxygen. For example, the substrate comprises a region (or preferably the entire substrate) having a concentration of oxygen of at least 1 × 10¹⁷ *at*/*cm³.*

Also, performing a "High-Low-High" annealing of the substrate has been observed to limit subsequent warpage.

By way of example, such an annealing can include:
a first annealing phase at a temperature 1050°C -1150°C (for example, this will allow diffusing oxygen present in the substrate);
following the first annealing phase, a second annealing phase at a temperature comprised between 700 and 800°C (for example, this will allow SiOx clusters to nucleate);
following the second annealing phase, a third annealing phase at a temperature of comprised between 1050°C and 1150°C (for example, this will allow SiOx precipitates to grow).

This annealing precedes patterning the substrate to obtain the bottom electrode structure. Also, obtaining the bottom electrode structure can include doping a portion of the substrate.

Here, the substrate 112 comprises reliefs (also called contours) to obtain the bottom electrode structure 110. For instance, it can comprise trenches, or holes. The subsequently formed capacitor will therefore be a 3D capacitor. This allows increasing the specific area of the capacitor for a given component size, and achieving a high capacitance density.

In particular, a substrate comprising reliefs presents a surface (here the top surface of the substrate 112, i.e. the bottom electrode structure 110) having portions that extend horizontally and vertically, i.e. that extend along three orthogonal directions.

A dielectric stack 120 is formed in a conformal manner on the bottom electrode structure. In other words, the stack is continuous and follows the contours of the underlying reliefs.

Obtaining a capacitor able to withstand voltages above 900V is done by using a dielectric stack having a thickness comprised between 2000 and 2500nm. The stack comprises:

-a thermal silicon dioxide layer (121) on the silicon substrate having a thickness comprised between 10% and 20% of the thickness of the dielectric stack,
- a SiₓN_{y} layer (122) on the thermal silicon dioxide layer having a thickness comprised between 45% and 55% of the thickness of the dielectric stack, and
- a deposited silicon dioxide layer (123)) on the SiₓN_{y} layer having a thickness comprised between 35% and 45% of the thickness of the dielectric stack.

This particular stack has been observed to prevent warpage and deformation of the device and of the wafer used to manufacture this device.

Above the dielectric stack and as shown on figure 2, a top electrode structure 130 extending on the dielectric stack 120 has been formed. This top electrode is deposited in a conformal manner so as to fill the gaps remaining in the 3D structure.

For example, the top electrode comprises doped (with phosphorous) polysilicon having a sheet resistance of more than 100 Ohm/sq. This corresponds to unannealed polysilicon. Maintaining the polysilicon unannealed limits the internal stress within the device.

At this stage, a capacitor is formed.

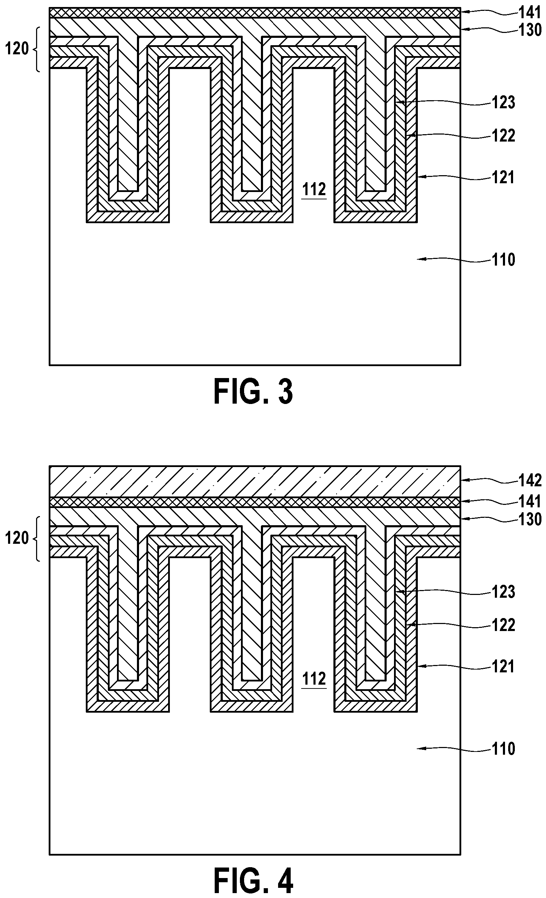

Subsequently and as shown on figure 3, a migration barrier layer 141 is deposited on the top electrode structure. Depositing this migration barrier layer is preferably performed by maintaining a temperature of the top electrode layer below 700°C.

Then and as shown on figure 4, a conductive region 142 is formed on the migration barrier layer. Conductive region 142 comprises AlSiCu. The temperature of the top electrode structure is maintained below 700°C until at least the beginning of forming the conductive region. Optionally, it can also be maintained below this temperature during forming the conductive region.

As the top electrode structure is unannealed, its interfaces are not stabilized, there is a risk that the AlSiCu will migrate within the polysilicon. The migration barrier layer prevents this migration.

The obtained device is particularly adapted for high voltage applications. Also, the resistivity of the unannealed polysilicon allows forming RC components.

Additional Variants: Although the present invention has been described above with reference to certain specific embodiments, it will be understood that the invention is not limited by the particularities of these specific embodiments. Numerous variations, modifications, and developments may be made in the above-described embodiments within the scope of the claims.

In particular, the present invention has been described in reference to a capacitor with a 3D capacitive structure. However, other embodiments of the present invention can also be used for planar capacitors.

It is to be understood that references in this text to directions and locations, such as "top" and "bottom", "front" and "rear", merely refer to the directions that apply when architectures and components are oriented as illustrated in the accompanying drawings.

## Claims

1. An electrical device comprising a capacitor including:
- a bottom electrode structure (110) comprising a silicon substrate (112),
- a dielectric stack (120) extending on the bottom electrode structure (110), the dielectric stack (120) comprising at least:
a thermal silicon dioxide layer (121) on the silicon substrate having a thickness comprised between 10% and 20% of the thickness of the dielectric stack,
a SiₓN_{y} layer (122) on the thermal silicon dioxide layer having a thickness comprised between 45% and 55% of the thickness of the dielectric stack, and
a deposited silicon dioxide layer (123)) on the SiₓN_{y} layer having a thickness comprised between 35% and 45% of the thickness of the dielectric stack,
- a top electrode structure (130) extending on the dielectric stack (120).

2. The electrical device according to claim 1, wherein the top electrode structure comprises doped polysilicon.

3. The electrical device according to claim 2, wherein the doped polysilicon has a sheet resistance of more than 100 Ohm/sq.

4. The electrical device of any one of claims 1 to 3, further comprising a migration barrier layer (141) arranged on the top electrode structure, for example comprising TiW.

5. The electrical device of claim 4, further comprising a conductive region (142) arranged on migration barrier layer.

6. The electrical device of claim 4 or 5, wherein the migration barrier layer has a thickness of less than 0.1µm.

7. The electrical device of any one of claims 1 to 6, wherein the silicon substrate of the bottom electrode structure comprises a region having a concentration of oxygen of at least 1 × 10¹⁷*at*/*cm³.*

8. The electrical device of any one of claims 1 to 7, wherein the dielectric stack has a thickness comprised between 2000 and 2500 nm.

9. The electrical device of any one of claims 1 to 8, wherein the bottom electrode structure comprises a surface presenting a relief, wherein the dielectric stack is arranged at least on the relief in a conformal manner.

10. A method for manufacturing an electrical device comprising a capacitor, said method comprising:
- providing a bottom electrode structure (110) comprising a silicon substrate (112);
- forming a dielectric stack (120) extending on the bottom electrode structure (110), comprising at least:
forming a thermal silicon dioxide layer (121) on the silicon substrate having a thickness comprised between 10% and 20% of the thickness of the dielectric stack, by thermal oxidation of the silicon substrate,
depositing a SiₓN_{y} layer (122) on the thermal silicon dioxide layer having a thickness comprised between 45% and 55% of the thickness of the dielectric stack, and
depositing silicon dioxide layer (123) on the SiₓN_{y} layer having a thickness comprised between 35% and 45% of the thickness of the dielectric stack,
- forming a top electrode structure (130) extending on the dielectric stack (120).

11. The method of claim 10, wherein the top electrode structure comprises doped polysilicon, the method further comprising forming a conductive region above the doped polysilicon, and the polysilicon remains unannealed during at least a continuous period including forming the top electrode structure and the beginning of forming a conductive region, for example by maintaining a temperature of the top electrode structure below 700°C at least during a continuous period including forming the top electrode and the beginning of forming a conductive region, or at least during a continuous period including forming the top electrode and forming a conductive region.

12. The method of claim 10 or 11, comprising annealing the silicon substrate of the bottom electrode structure including:
a first annealing phase at a temperature 1050°C -1150°C;
following the first annealing phase, a second annealing phase at a temperature comprised between 700 and 800°C;
following the second annealing phase, a third annealing phase at a temperature of comprised between 1050°C and 1150°C.
